# EUROPEAN PATENT SPECIFICATION

(11) **EP 0 749 163 B1**
(45) Date of publication and mention of the grant of the patent: **21.10.1998**
(21) Application number: 96114655.2
(22) Date of filing: 06.01.1995
(51) Int. Cl.: H01L 29/06, H01L 29/78, H01L 29/10, H01L 29/739

(54) **MOS type semiconductor device**
Halbleiterbauelement vom MOS-Typ
Dispositif semiconducteur du type MOS

(30) Priority: 07.01.1994 JP 364/94; 24.05.1994 JP 108873/94; 10.11.1994 JP 276196/94
(43) Date of publication of application: 18.12.1996
(62) Divisional of application: 95100148.6
(73) Proprietor: FUJI ELECTRIC CO. LTD., Kawasaki 210 (JP)
(72) Inventor: Fujihara, Tatsuhiko, Kawasaki-ku, Kawasaki 210 (JP); Nishimura, Takeyoshi, Kawasaki-ku, Kawasaki 210 (JP); Kobayashi, Takashi, Kawasaki-ku, Kawasaki 210 (JP); Arai, Toshihiro, Kawasaki-ku, Kawasaki 210 (JP)
(74) Representative: Hoffmann, Eckart, Dipl.-Ing.

(56) References cited:
- EP-A- 0 570 595
- US-A- 5 216 275
- PATENT ABSTRACTS OF JAPAN vol. 13, no. 571 (E-862), 18 December 1989 & JP-A-01 238173 (SANYO), 22 September 1989,
- PATENT ABSTRACTS OF JAPAN vol. 14, no. 408 (E-972), 4 September 1990 & JP-A-02 154468 (SANKEN ELECTRIC), 13 June 1990,

## Description

The present invention relates to a MOS type semiconductor device such as a MOS field effect transistor (hereinafter referred to as MOSFET), an insulated gate bipolar transistor etc., which is comprised of a plurality of source regions, which have a gate with a metal - oxide film - semiconductor (MOS) structure, scattered in a surface layer of a semiconductor substrate.

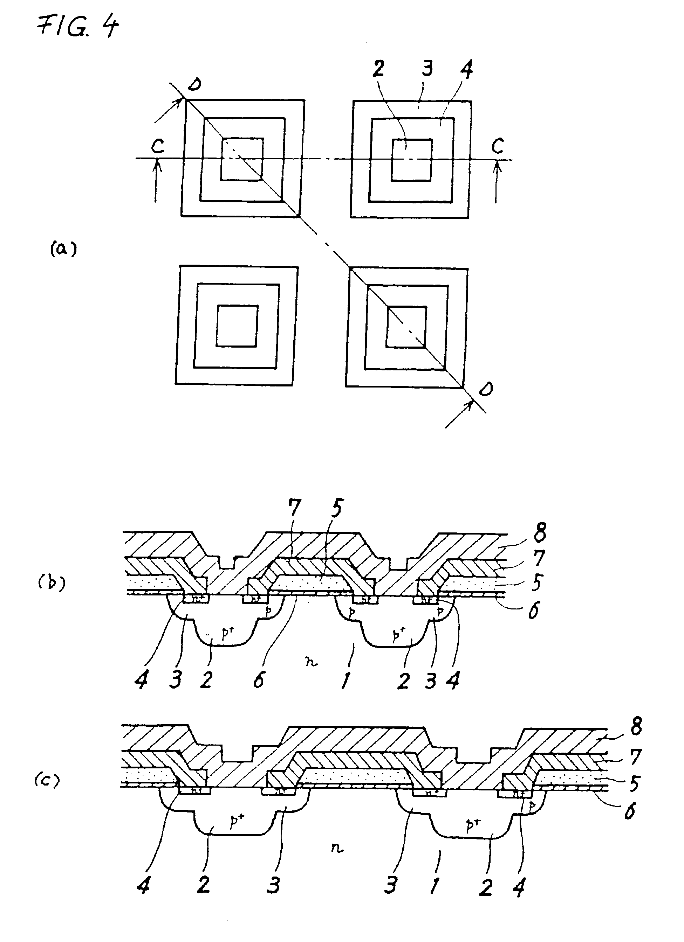

The MOS type semiconductor device has been used very often in switching circuits because of its low ON-resistance and fast switching speed. Figs. 4(a) to 4(c) show an example of a conventional MOS type semiconductor device, in which Fig. 4(a) is a top plan view, Fig. 4(b) a sectional view along C-C of Fig. 4(a), and Fig. 4(c) a sectional view along D-D of Fig. 4(a). In Figs. 4, a plurality of quadrangular p⁺ well regions 2 are formed in a surface layer of an n⁻ type semiconductor substrate 1. A plurality of quadrangular p channel regions 3 are formed around the p⁺ well diffusion layers 2. An n⁺ source region 4 is formed in a surface layer of the p channel region 3. A gate electrode 5, made for example of polycrystalline silicon, is disposed through a gate oxide film 6 over the surface of the p channel region 3 between the source region 4 and the exposed surface of the n⁻ type substrate. A source electrode 8 of Al-Si alloy, which contacts commonly with the p⁺ well region 2 and the n⁺ source region 4 and is insulated from the gate electrode 5 by an inter-layer insulation film 7 of BPSG (boron phosphorus silicate glass), is extended over the gate electrode 5. Hereinafter, a unit structure comprised of the p channel region 3, the n⁺ source region 4, and the source electrode 8 as shown in Figs. 4 is referred to as "quadrangular cell". Though the term "quadrangular cell" is used here, the corners of the cells rarely have an angle of 90° or less. In actual semiconductor devices, the corners of the cells are more or less rounded, or the actual cell is formed in an octagon by cutting off the corners of a quadrangular cell. Hereinafter, a polygonal cell, which is defined by two pairs of parallel major sides and extensions of the non-parallel major sides of which cross at around a right angle, will be referred to a "quadrangular cell". When the non-parallel major sides do not cross, the corner of the quadrangular cell is assumed to be located near the cross point of the extensions of the non-parallel major sides and a diagonal of the quadrangular cell is defined as a line segment connecting the assumed corners opposed facing. In the actual semiconductor device, e.g. MOSFET, many quadrangular cells are arranged side by side.

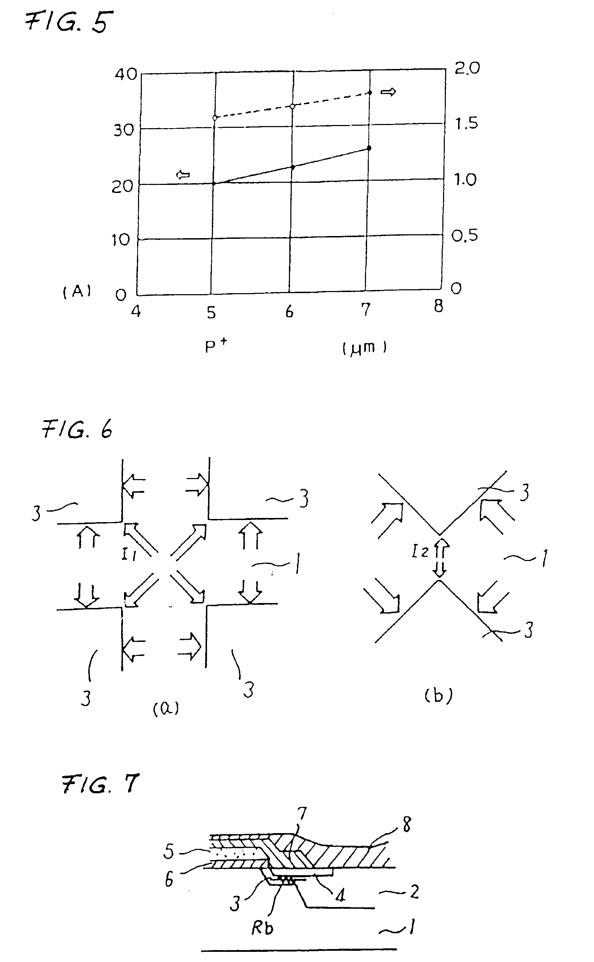

Since, recently, snubber circuits have been eliminated from switching circuits for circuit simplification and since the down-sizing of the switching circuits has proceeded, MOSFETs used as a switching device in the switching circuits tend to be affected by surge voltage. Since the surge voltage causes breakdown of the MOSFET, improvement of breakdown withstand capability (avalanche withstand capability) of the MOSFETs has been required. In the above described conventional MOSFET, the p⁺ well region 2 is formed deeply to improve the avalanche withstand capability. However, the deep p⁺ well region affects other properties such as the ON-resistance of the MOSFET. Fig. 5 shows the avalanche withstand capability and the ON-resistance versus p⁺ well depth relations in a MOSFET element with ratings of 900 V and 5 A. In Fig. 5, the abscissa represents the diffusion depth of the p⁺ well region 2 and the ordinate represents the avalanche withstand capability and the ON-resistance, respectively. As shown in Fig. 5, the avalanche withstand capability is improved with increasing depth of the p⁺ well region. However, the ON-resistance increases also with increasing depth of the p⁺ well region. Therefore, it takes a considerable period of time to experimentally determine the manufacturing process parameters for obtaining a depth of the p⁺ well region at which the avalanche withstand capability is appropriately balanced with the ON-resistance. And, if the avalanche withstand capability is balanced with the ON-resistance, improvement of the avalanche withstand capability remains within a limited range.

The documents JP-A-238173/1989 (corresponding to the preamble of claim 1) and JP-A-154468/1990 both disclose a MOS type semiconductor device comprising a plurality of substantially quadrangular cells, each having four major sides. To avoid electric field concentrations at the cell corners the cells are arranged in such a way that the distance between two facing corners of the channel regions (3) of two neighboring quadrangular cells is shorter than the distance between facing sides of the channel regions of the two neighboring quadrangular cells.

US-A-5,216,275 discloses a MOS type semiconductor device comprising a plurality of substantially equal cells. The cells are formed on what is called a CB (composite buffer) layer. The CB layer has an interdigital, hexagonal or square mosaic structure of p and n regions.

EP-A-0 570 595 discloses a MOS type semiconductor device, comprising a semiconductor layer of a first conductivity type and a plurality of cells, each including a channel region of a second conductivity type formed in a surface layer of the semiconductor layer, and a source region of the first conductivity type formed in the surface layer of the channel region. A shallow base contact region of a second-conductivity type with an impurity concentration higher than that of the channel region and a diffusion depth shallower than that of the channel region, is formed in a portion of the surface layer of the channel region within the source region. A semiconductor region of the first conductivity type is disposed in the surface layer of said semiconductor layer between the channel regions of two adjacent cells, the resistivity of the semiconductor region being smaller than that of said semiconductor layer.

In view of the foregoing, an object of the present invention is to provide a MOS type semiconductor device which improves avalanche withstand capability without sacrificing other properties.

This object is achieved with a MOS type semiconductor device as claimed in claim 1.

Preferred embodiments of the inventions are subject matter of the dependent claims.

The avalanche withstand capability is improved by minimizing the curvature of the pn junctions in the peripheral and corner cells surrounding the quadrangular cells, and by widening the areas of the peripheral and corner cells. The avalanche withstand capability is further improved by lowering the channel resistance by means of the shallow base region formed in the channel region.

The invention will be explained in detail below with reference to the drawings which illustrate specific embodiments only and in which:
- Fig. 1: is a top plan view showing a first embodiment of a MOSFET of the present invention;
- Fig. 2(a): is a sectional view taken along line A-A in Fig. 1;
- Fig. 2(b): a sectional view taken along line B-B of Fig. 1;
- Fig. 3: is a sectional view showing a portion around the periphery of the MOSFET chip of Fig. 1;
- Fig. 4(a): is a top plan view showing an example of the MOSFET according to the prior art;
- Fig. 4(b): is a sectional view taken along line C-C in Fig. 4(a);
- Fig. 4(c): is a sectional view taken along line D-D in Fig. 4(a);
- Fig. 5: is a graph showing the avalanche withstand capability and ON-resistance, respectively, versus the p⁺ well depth of the MOSFET;
- Fig. 6(a): is a top plan view for explaining the flow of avalanche currents in the conventional MOSFET;
- Fig. 6(b): is a top plan view for explaining the flow of avalanche currents in a MOSFET of the present application;
- Fig. 7: is a sectional view showing a parasitic bipolar transistor which appears near the surface of the MOSFET;
- Fig. 8: is a graph comparing the temperature variation of the avalanche withstand capabilities of the MOSFETs of the present application and the conventional MOSFET;
- Fig. 9: is a top plan view showing a second embodiment of the MOSFET according to the present invention from which an upper structure of the MOSFET is omitted;
- Fig. 10(a): is a sectional view taken along line E-E in Fig. 9;
- Fig. 10(b): a sectional view taken along line F-F in Fig. 9;
- Fig. 11: is a sectional view showing a further example of the MOSFET;
- Fig. 12: is a sectional view showing a further example of the MOSFET;
- Fig. 13: is a top plan view showing a third embodiment of a MOSFET of the present invention;
- Fig. 14(a): is a sectional view taken along line A-A in Fig. 13, and
- Fig. 14(b): a sectional view taken along line B-B in Fig. 13.

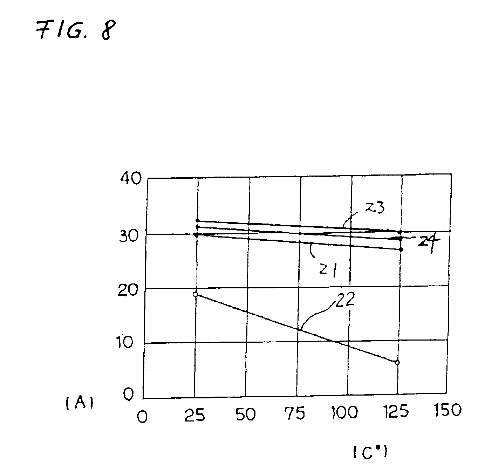

Fig. 6(a) is a top plan view for explaining the flow of avalanche currents in the conventional MOSFET, and Fig. 6(b) is a top plan view for explaining the flow of avalanche currents in the MOSFET according to the present invention. In Fig. 6(a), the distance between the channel regions 3 around the corners of the cells shown in Fig. 4(c) is longer than the distance between the sides of the channel regions 3. Since a withstand voltage is low around the corner of the cells because of the large curvature of the p channel region 3, the avalanche currents 11 caused by avalanche breakdown concentrate to the four corners of the p channel regions 3 from a region surrounded by the four corners of the channel regions 3 as shown in Fig. 6(a). Because of this, the avalanche withstand capability of the MOSFET lowers around the corner of the quadrangular cells. In contrast, if two quadrangular cells are aligned in close proximity with each one of their diagonals lying on a line as shown in Fig. 6(b), this configuration encourages pinch-off of a depletion layer around the corner of the quadrangular cells and prevents the withstand voltage from lowering. Since avalanche currents 12 flow to two opposed facing corners of the channel regions 3, arranged in close proximity to each other, from a narrow region between the two opposed facing corners of the channel regions 3 as shown in Fig. 6(b), the current 12 decreases to half the current I1. As a result, the avalanche current, which flows through the resistance Rb of the p channel region 3 beneath the n⁺ source region 4 shown in Fig. 7, decreases. The avalanche current decrease prevents a parasitic bipolar transistor, consisted of the semiconductor layer of the first conduction type, the channel region of the second conduction type and the source region of the first conduction type, from mal-firing, and therefore, prevents the MOSFET from being broken down. In this configuration, narrower distance between the channel regions of the two cells is preferable, and the distance of 4 µm or less effectively prevents the MOSFET from breakdown. And, a configuration, in which channel regions are so formed by horizontal diffusion that corners of the channel regions of the neighboring cells are joined to each other on the cell diagonals, most effectively prevents the MOSFET from breakdown.

By aligning at least a portion of the outermost side of the channel region of the peripheral cells, formed on the outermost periphery, inside of which the quadrangular cells are formed, in parallel to the side of the semiconductor chip, the pn junction is formed in straight and localization of the electric field is suppressed. By forming the source region of the peripheral cell only on its central side of the semiconductor chip, the parasitic transistor is prevented from operating even when the avalanche current flows, because the source region of the first conductivity type is not formed on the peripheral side of the peripheral cell. And, by expanding the area of the peripheral cell more widely than the area of the quadrangular cell, the avalanche energy absorption capability, and therefore, the avalanche withstand capability are improved.

By forming the corner cells, the outermost side of a channel region of which is an arc convex toward the corner of the semiconductor chip or a polygonal curve imitating the arc, in the corners of the semiconductor chip, the curvature of the pn junction is reduced and the localization of the electric field is suppressed. And, by expanding the area of the corner cell more widely than the area of the quadrangular cell, the avalanche energy absorption capability, and therefore, the avalanche withstand capability are improved.

The provision of a shallow base region of a second conductivity type, the impurity concentration of which is higher than the impurity concentration of the channel region and the diffusion depth of which is shallower than the diffusion depth the channel region, in a portion of the surface layer of the channel region, improves the avalanche withstand capability, because the conductivity of the channel region increases, the base resistance of the parasitic transistor decreases, and therefore, the parasitic transistor hardly operates. Especially, by providing the region of the second conductivity type under the shallow base region only with the channel region, the avalanche withstand capability is improved even when the well region of the second conductivity type does not exist.

### Preferred Embodiments

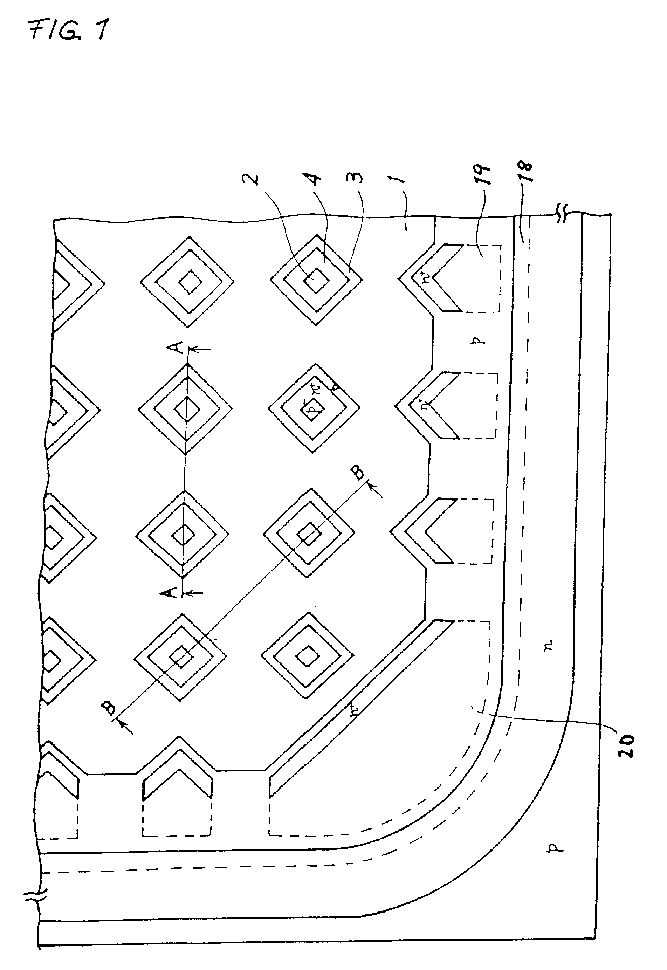

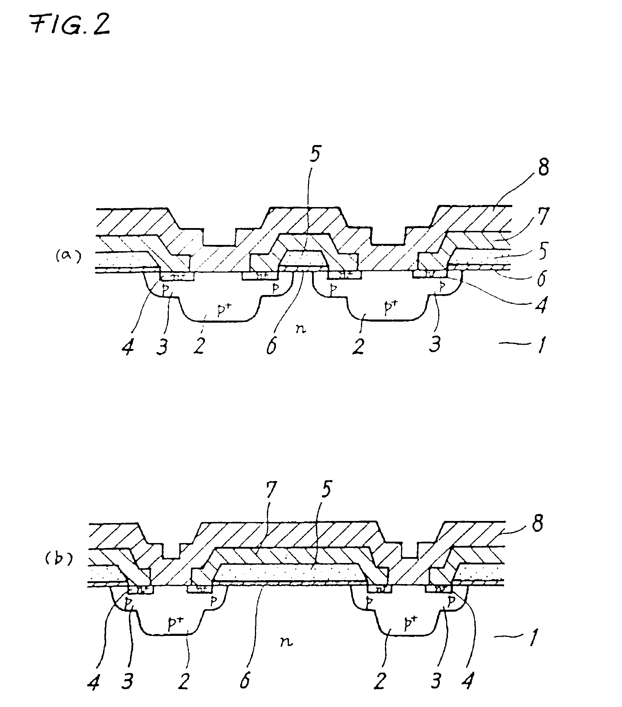

Fig. 1, Fig. 2(a) and Fig. 2 (b) show a first embodiment of a MOSFET of the present invention. Fig. 1 is a top plan view, Fig. 2(a) a sectional view along A-A of Fig. 1, and Fig. 2(b) a sectional view along B-B of Fig. 1. In Figs. 1, 2(a) and 2(b), the same parts with those in Figs. 4 are designated by the same reference numerals.

As shown in Fig. 1, quadrangular cells, each of which has four major sides and is comprised of a quadrangular p channel region 3, an n⁺ source region 4 and a p⁺ well region 2 formed in the p channel region 3, are arranged with their corners positioned in the closest proximity. Though the diagonals of two nearest or eaxh pair of nearest neighboring quadrangular cells are aligned on a line, since the cells are arranged with equal pitch in this embodiment, the quadrangular cells may be rectangular. In practice, the corner of the quadrangular cell is not right angled, and curved with a radius of curvature of 1.5 to 2 µm. As explained with reference to Fig. 6, the avalanche current around the corners of the neighboring quadrangular cells is small. Though the region surrounded by four quadrangular cells is wide and the avalanche current is large, the surrounding quadrangular cells withstand a large avalanche current, because the opposed facing pn junctions are straight. In Fig. 2(a), the p channel region 3 is formed in the surface layer of the n⁻ type substrate 1 with a resistivity of 45 Ωcm and a thickness of 100 µm. The p⁺ well region 2 deeper than the p channel region 3 is formed from the surface of the p channel region 3, and the n⁺ source region 4 is formed in the surface layer of the p⁺ well region 2. A polycrystalline silicon gate electrode 5 is disposed through a gate oxide film 6 on the surface of the p channel region 3 between the n⁺ source region 4 and the exposed portion of the substrate 1. A source electrode 8 is disposed in contact commonly with the n⁺ source region 4 and the p⁺ well region 2 and extends over the gate electrode 5 through an inter-layer insulation film 7. A drain electrode (not shown) is deposited on the back surface of the n⁻ type substrate through an n⁺ type substrate layer. The parameters of an experimental model of the MOSFET of Fig. 1 are as follows. The dose amount in the p channel region 3 by ion implantation is 1x10¹⁴ cm⁻²; the diffusion depth of the p channel region 3 is 3 µm; the dose amount in the p⁺ well region 2 is 1x10¹⁵ cm⁻²; the diffusion depth of the p⁺ well region 2 is 8 µm; the dose amount in the n⁺ source region 4 is 5x10¹⁵ cm⁻²; and the diffusion depth of the n⁺ source region 4 is 0.3 µm. The size of the p channel region 3 is 33 µm x 33 µm, and the pitch between the p channel regions 3, 3 is 50 µm. At this pitch, the distance between the corners of two the p channel regions 3, 3 is about 4 µm.

Since two quadrangular cells are positioned most closely across the opposed facing corners of the p channel regions 3, 3, as illustrated in the A-A section shown in Fig. 2(a), a depletion layer which spreads from the p channel region 3 when an electric field is applied easily joins a depletion layer spreading from the adjacent p channel region 3. Since the curvature of the depletion layer is usually small, withstand voltage lowering at the corners of the quadrangular cell, at which avalanche breakdown occurs most easily, does not take place and the avalanche withstand capability is improved. Since the portion of the n⁻ type substrate under the gate electrode 5 is widely spaced between two quadrangular cells in the cross section shown in Fig 2(b), a wide current path is obtained when the MOSFET is ON, and the ON-resistance of the MOSFET is suppressed at low value.

In Fig. 1, peripheral cells 19, the outermost side of which lies in parallel to the side of the semiconductor chip, and corner cells 20, the outermost side of which is arched toward the corner of the semiconductor chip, are arranged outside the portion of the semiconductor chip in which the quadrangular cells are arranged. Since the curvature of the outermost pn junctions becomes small by this arrangement, the electric field hardly localizes and the avalanche withstand capability is improved. An n⁺ source region 4 is formed in a portion of the peripheral cell 19 and the corner cell 20 located on the side of the central part of the chip. The avalanche withstand capability is improved by the following reason. Though the avalanche breakdown usually starts at first from the outermost pn junction, since the portion lacks n⁺ source region, the parasitic transistor does not work even when a large avalanche current flows and the avalanche withstand capability is improved. Since the peripheral cell 19 and the corner cell 20 absorb more avalanche energy by virtue of their greater areas than that of the quadrangular cell, the avalanche withstand capability is further improved. The broken line near the peripheral cell 19 indicates a boundary of a polycrystalline silicon ring 18. The outermost side of the p channel region of the corner cell 20 is not necessarily an arc convex towards the corner of the semiconductor chip. Even an outermost polygonal side imitating an arc is effective for avoiding the electric field localization.

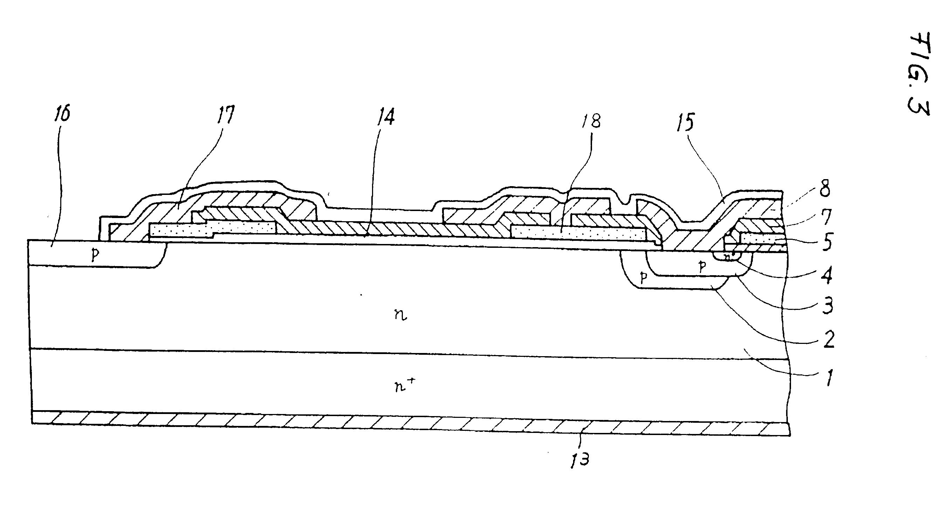

Fig. 3 is a sectional view showing a portion around the periphery of the MOSFET chip. A polycrystalline silicon ring 18 for leading out gate leads is disposed on the outermost p⁺ well region 2 through a thick field oxide film 14, and a p peripheral region 16 is disposed in the surface layer of the periphery of the chip. A peripheral electrode 17 is disposed on the p peripheral region 16.

The parameters of each part are as follows. The impurity concentration of the n⁻ type substrate is 1x10¹³ to 3x10¹⁶ cm⁻³; the thickness of the n⁻ type substrate is 5 to 150 µm; the boron ion dose amount in the p⁺ well region 2 is 5x10¹⁴ to 2x10¹⁵ cm⁻²; the diffusion depth of the p⁺ well region 2 is 5 to 10 µm; the boron ion dose amount in the p channel region 3 is 3x10¹³ to 5x10¹⁴ cm⁻²; the diffusion depth of the p channel region 3 is 2 to 4 µm; the arsenic ion dose amount in the n⁺ source region 4 is 4x10¹⁵ to 5x10¹⁵ cm⁻²; the diffusion depth of the n⁺ source region 4 is 0.2 to 0.3 µm; the thickness of the gate electrode (polysilicon) 5 is 500 to 1000 nm; the thickness of the gate oxide film 6 is 25 to 120 nm; the thickness of the interlayer insulation film (BPSG) 7 is 0.6 to 1.1 µm; the thickness of the source electrode (Al-Si) 8 is 3 to 5 µm; the thickness of the field oxide film 14 is 500 to 1100 nm; and the thickness of the passivation film (SiN) 15 is 800 nm. As for the p type base region, the following three combination can be adopted: (1) the p channel region 3 and the p+ well region 2; (2) the p channel region 3 and a shallow p+ type base region 11; (3) the p channel region 3, the p+ well region 2, and the shallow p+ type base region 11.

The first MOSFET of Figs. 1 and 2 operates as follows. When a positive voltage of more than a predetermined value is applied to the gate electrode 5, an inversion layer is yielded near the surface of the p channel region 3 underneath the gate electrode 5 and the portion between the n⁺ source region 4 and the n⁻ type substrate becomes conductive. And a current flows if a voltage is applied at this instance between the drain electrode 13 disposed on the back surface of the n⁻ type substrate and the source electrode 8. It is necessary for the exposed portion of the n⁻ type substrate to have an area wide enough for the current to flow. Usually, there exists an optimum value for the ratio of the area of the cells to the exposed area of the n⁻ type substrate. If the distance between the corners of two p channel regions is set too long, the exposed area of the n⁻ type substrate occupies too wide an area, which causes ON-resistance increase. If the distance between the corners of two p channel regions is set too short, the exposed area of the n⁻ type substrate occupies too narrow an area, which also causes ON-resistance increase. The optimum ratio is 0.7 for the high withstand voltage MOSFET of the 900V class. When the distance between the corners of two p channel regions is set at 4 µm, the ratio is 0.7. The optimum ratio for a lower withstand voltage MOSFET is more than 0.7, corresponding to which the optimum distance between the corners of two p channel regions becomes shorter than 4 µm.

Fig. 8 is a graph for comparing the temperature dependence of the avalanche withstand capability of the MOSFET of Figs. 1 and 2 of the present invention with that of the conventional MOSFET of Fig. 4. The withstand capability of the MOSFET of the present application shown by a line 21 is 1.6 times at 25°C and 4.7 times at 125°C as large as the withstand capability of the conventional MOSFET, the cell dimensions of which are the same with those of the MOSFET of the present application: the area of the p channel region is 33 µm x 33 µm, and the pitch between the quadrangular cells is 50 µm.

In the first embodiment of Fig. 1, the exposed area of the n⁻ type substrate is almost entirely covered by the polycrystalline silicon gate electrode 5. Though the gate electrode is narrow between the corners of the quadrangular cells, since the narrow portion is short, the overall gate resistance is lowered as compared with the gate resistance of the conventional MOSFET.

The first embodiment of the present MOSFET can be manufactured only by changing the mask pattern without adding extra processing steps to the processing steps for the MOSFET of the prior art.

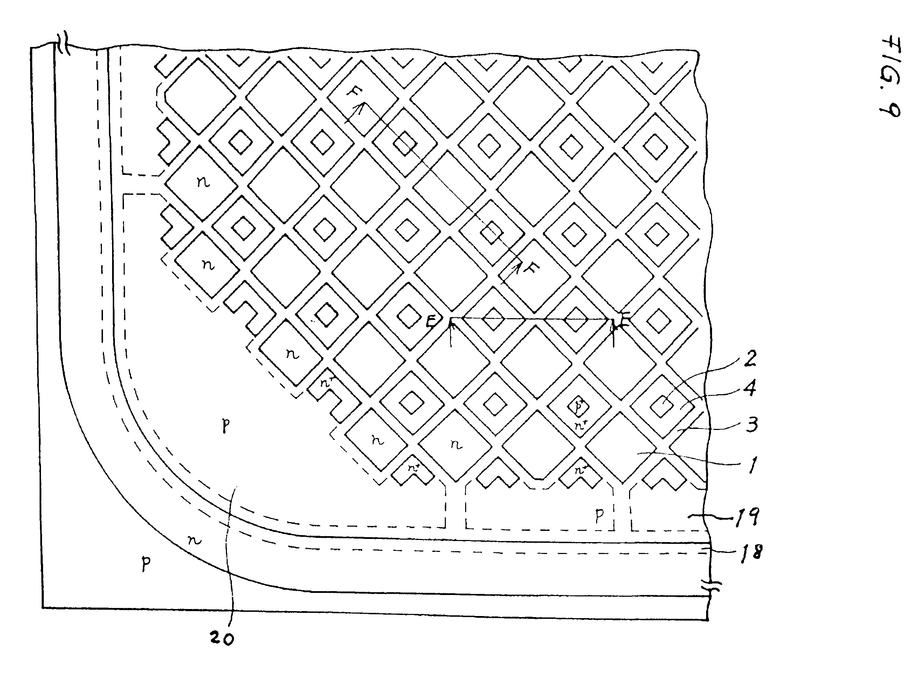

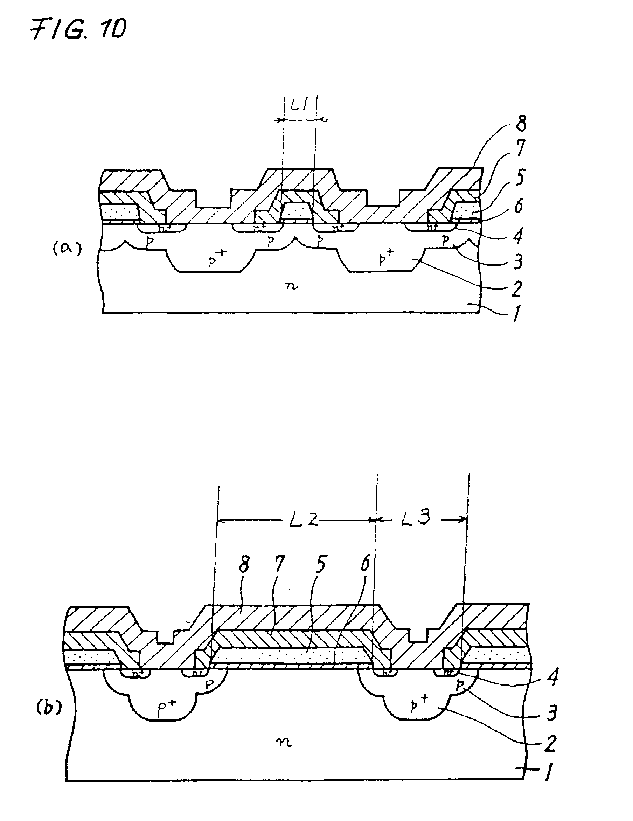

Figs. 9, 10(a) and 10(b) show a second embodiment of the MOSFET according to the present invention. Fig. 9 is a top plan view from which an upper structure of the MOSFET is omitted, Fig. 10(a) a sectional view along E-E of Fig. 9, and Fig. 10(b) a sectional view along F-F of Fig. 9(a). In Figs. 9, 10(a) and 10(b), the same parts with those in the figures already explained are designated by the same reference numerals. In Fig. 9, the space between the corners of the quadrangular cells is further narrowed from that of Fig. 1 until the p channel regions 3 of two nearest neighboring quadrangular cells join each other at their corners. In Fig. 9, the n⁺ source region 4 is formed in the joined p channel regions 3, and the p⁺ well region 2 is formed in the n⁺ source region 4. The E-E section shown in Fig. 10(a) clearly illustrates the junction of the p channel regions 3. The neighboring p channel regions 3 join each other underneath the gate electrode 5, by which the withstand voltage at the corner of the quadrangular cell and the avalanche withstand capability are prevented from lowering. The width L1 of the gate electrode 5 is 2 to 6 µm at the corner. In the F-F section shown in Fig. 10(b), two quadrangular cells are spaced widely enough and the n⁻ type substrate is exposed widely enough to suppress the ON-resistance of the MOSFET at a low value when the MOSFET is conductive. The width L2 of the gate electrode 5 is 6 to 20 µm and the distance L3 between the gate electrodes 5, 5 is 6 to 12 µm in this cross section. In the second embodiment too, the peripheral cells 19 are formed in the outermost periphery of the portion of the semiconductor chip inside which the quadrangular cells are formed. The outermost side of p channel region 3 of the peripheral cell 19 lies in parallel to the side of the semiconductor chip, and the n⁺ source region 4 in the peripheral cell 19 is located on the inner side of the semiconductor chip. The peripheral cell 19 occupies a greater area than the quadrangular cells. The outermost side of p channel region 3 of the corner cell 20 arches toward the corner of the semiconductor chip, and the corner cell 20 occupies a wider area than the peripheral cell 19. By this configuration, the second embodiment also contributes to the improvement of the avalanche withstand capability.

The temperature dependence of the avalanche withstand capability of the second embodiment of the MOSFET is shown by the line 23 in Fig. 8. The avalanche withstand capability of the second embodiment of the MOSFET is 1.8 times at 25°C and 5.0 times at 125°C as large as the withstand capability, shown by the line 22, of the MOSFET according to the prior art.

In the second embodiment of Fig. 9, the ratio of the area of the quadrangular cell to the exposed area of the n⁻ type substrate can be brought beyond 1.0 by overlapping the quadrangular cells at their corners. Therefore, the second embodiment is preferable to the MOSFET with relatively low withstand voltage.

The second embodiment of the present MOSFET can be also manufactured only by changing the mask pattern without adding extra processing steps to the processing steps for the MOSFET of the prior art.

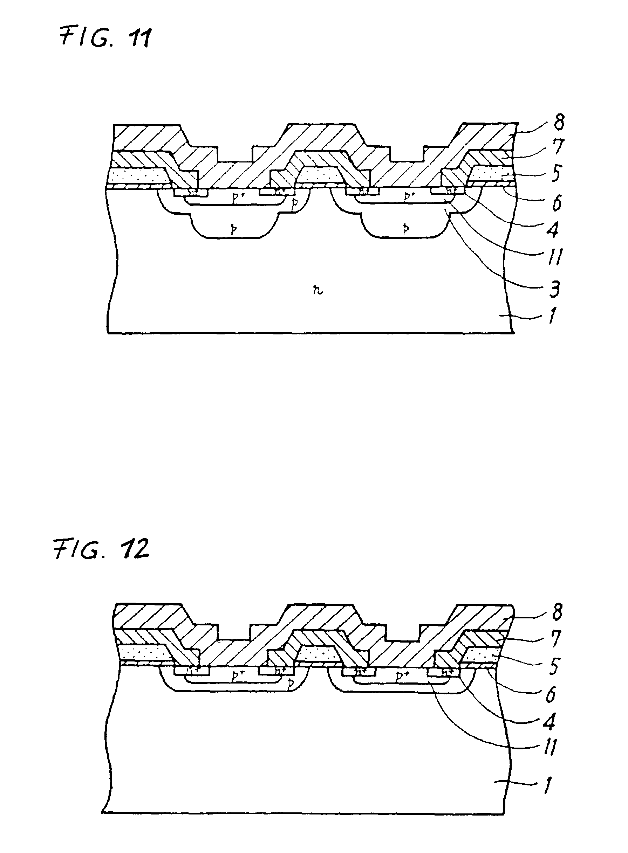

Fig. 11 is a sectional view showing a further example of a MOSFET. In Fig. 11, the same parts with those in the figures already explained are designated by the same reference numerals. A shallow p⁺ type base region 11 with shallow diffusion depth and with higher impurity concentration than that of the p channel region 3 is formed in a part of the surface layer of the p channel region 3 of Fig. 2. The shallow p⁺ base region 11 is formed, for example, by implanting boron ions at the ion dose amount of 1x10¹⁵ to 3x10¹⁵ cm⁻²; and by heat treatment to the diffusion depth of 0.5 to 1 µm. Since the channel resistance is lowered by the shallow p⁺ type base region 11, the operation of the parasitic transistor is suppressed and the avalanche withstand capability is improved.

Fig. 12 is a sectional view showing a further example of the MOSFET. In Fig. 12, the same parts with those in the figures already explained are designated by the same reference numerals. The shallow p⁺ type base region 11 with higher impurity concentration than that of the p channel region 3 is formed in a part of the surface layer of the p channel region 3 similarly as in the example of Fig. 11. However, the p⁺ well region 2 is not formed in the example of Fig. 12. Since the channel resistance is lowered by the provision of the shallow p⁺ type base region 11 as well as by the improvement of the cell arrangement, the operation of the parasitic transistor is suppressed and the avalanche withstand capability is improved. Therefore, a practically acceptable avalanche withstand capability is obtained and the problem of the ON-resistance decrease mentioned earlier is solved without forming the p⁺ well region 2. Since the p⁺ well region 2 with deep diffusion depth can be omitted, time and cost for manufacturing the MOSFET is greatly saved.

Though the present invention has been explained with reference to MOSFETs, the present invention is applicable to other MOS semiconductor devices such as bipolar transistors, MCTs (MOS controlled thyristors), etc. which have a MOS structure.

A MOS type semiconductor device could be possible which includes an n type region 101, whose resistivity is lower than that of the n⁻ type substrate and which is disposed in the vicinity of the surface of the n⁻ type substrate between the p channel regions 3. However, the avalanche withstand capability in this case would hardly be improved and ON-resistivity reduction by the effect of the low resistivity n type region 191 would be limited. On the other hand, in the semiconductor device, lower resistivity in the n type region is possible because doping concentration in the n type region 101 can be increased without deterioration of the avalanche withstand capability or withstand voltage. An embodiment of this case is described below.

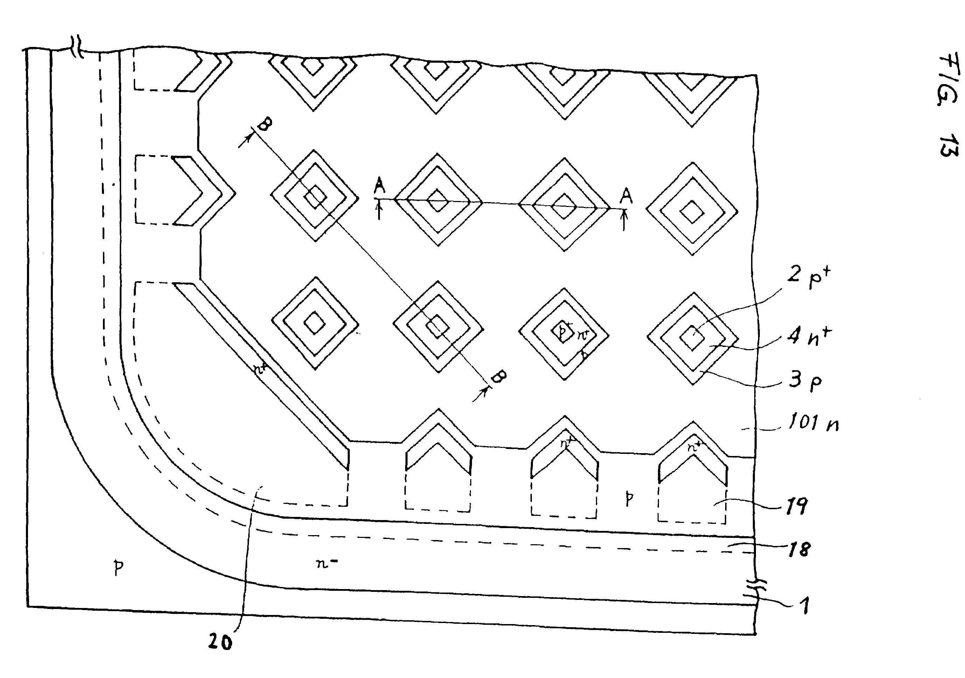

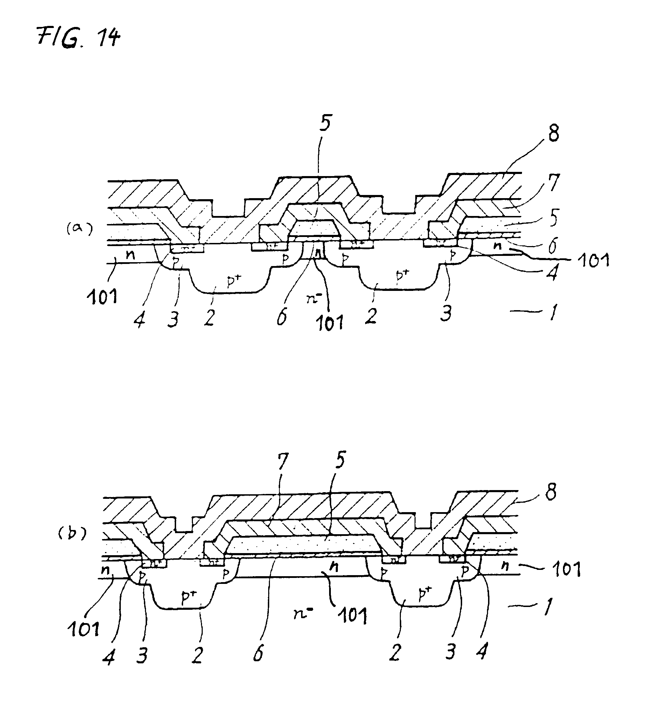

In Figs. 13 and 14, n type regions 101 are formed in the vicinity of the surface of the n⁻ type substrate. Resistivity of the n type regions 101 is lower than that of the n⁻ type substrate. The dose amount of the phosphor ions in the n type regions 101 is from 5 x 10¹¹ to 5 x 10¹² cm⁻² and the diffusion depth is from 2 to 4 µm. The construction of the n type regions of this type can be applied to the embodiments in Figs. 9 through 12.

In the embodiments described above, the doping concentration can be increased in comparison with the prior art devices, which results in lower resistivity of the n type regions 101 and thus decreases the ON-resistance. Or, alternatively, the surface area of the n type regions 101 can be reduced proportionally to its decrease in resistivity, which in turn reduces source-drain capacitance ensuring fast switching speed.

## Claims

1. A semiconductor chip comprising a MOS type semiconductor device, comprising a semiconductor layer (1) of a first conductivity type (n) and a plurality of inner and substantially quadrangular cells, each having four major sides and including a channel region (3) of a second conductivity type (p) formed in a surface layer of the semiconductor layer (1), and a source region (4) of the first conductivity type (n) formed in the surface layer of the channel region, the sides thereof lying in parallel to the sides of the source region, wherein the distance between corners of the channel regions (3) of two neighboring inner quadrangular cells, said corners thereof being opposed facing to each other, is shorter than the distance between sides of the channel regions of two other neighboring inner quadrangular cells, the sides thereof are opposed facing to each other
characterized in that
peripheral cells (19) formed in the surface layer of the semiconductor layer (1) and which have at least a portion of the outermost side of their channel region of the second conductivity type in parallel to a side of the semiconductor chip, are formed on the outermost periphery, inside of which the inner quadrangular cells are formed, of the semiconductor chip, and
the area of a peripheral cell (19) is greater than the area of an inner quadrangular cell.

2. The MOS type semiconductor device as claimed in claim 1, wherein corner cells (20) which have the outermost side of their channel region of the second conductivity type as an arc convex toward the corner of the semiconductor chip, are formed in the corners of the semiconductor chip, and wherein the area of a corner cells (20) is greater than the area of a peripheral cell (19).

3. The MOS type semiconductor device as claimed in claim 1, wherein corner cells (20) which have the outermost side of their channel region of the second conductivity type as a polygonal line imitating an arc convex toward the corner of the semiconductor chip, are formed in the corners of the semiconductor chip, and wherein the area of a corner cells (20) is greater than the area of a peripheral cell (19).

4. The MOS type semiconductor device of claim 1, 2 or 3 further including a semiconductor region (101) of a first conductivity type (n) disposed in the surface of said semiconductor layer (1) between the parallel sides of two neighboring inner quadrangular cells, the resistivity of the semiconductor region (101) being smaller than that of said semiconductor layer (1).

5. The MOS type semiconductor device as claimed in either one of claims 1 to 3, wherein a shallow base region (11) of a second conductivity type (p) with an impurity concentration higher than that of the channel region (3) and a diffusion depth shallower than that of the channel region, is formed in a portion of the surface layer of the channel region and the region of the second conductivity type (p) under the shallow base region (11) consists of the channel region (3).

## Patentansprüche

1. Ein Halbleiterchip umfassend ein Halbleiterbauelement des MOS-Typs, mit einer Halbleiterschicht (1) eines ersten Leitungstyps (n) und einer Mehrzahl von inneren und im wesentlichen viereckigen Zellen, die jeweils vier Hauptseiten aufweisen und eine Kanalzone (3) eines zweiten Leitungstyps (p), die in einer Oberflächenschicht der Halbleiterschicht (1) ausgebildet ist, und eine Sourcezone (4) des ersten Leitungstyps (n) enthalten, die in der Oberflächenschicht der Kanalzone ausgebildet ist, wobei die Seiten der Kanalzone parallel zu den Seiten der Sourcezone liegen, wobei der Abstand zwischen Ecken der Kanalzonen (3) von zwei benachbarten inneren viereckigen Zellen, deren Ecken sich gegenüberliegen und einander zugewandt sind, kürzer ist als der Abstand zwischen einander gegenüberliegenden und sich zugewandten Seiten der Kanalzonen zweier anderer benachbarter innerer viereckiger Zellen,
**dadurch gekennzeichnet**, daß
äußere Zellen (19), die in der Oberflächenschicht der Halbleiterschicht (1) ausgebildet sind und von denen wenigstens ein Abschnitt der äußersten Seite ihrer Kanalzone des zweiten Leitungstyps parallel zu einer Seite des Halbleiterchips liegt, im äußersten Randbereich des Halbleiterchips ausgebildet sind, innerhalb dessen die inneren viereckigen Zellen ausgebildet sind, und
die Fläche einer äußeren Zelle (19) größer als die Fläche einer inneren viereckigen Zelle ist.

2. Halbleiterbauelement des MOS-Typs nach Anspruch 1, bei dem in den Ecken des Halbleiterchips Eckzellen (20) ausgebildet sind, bei denen die äußerste Seite ihrer Kanalzone des zweiten Leitungstyps als ein zur Ecke des Halbleiterchips konvexer Bogen ausgebildet ist, wobei die Fläche einer Eckzelle (20) größer ist als die Fläche einer äußeren Zelle.

3. Halbleiterbauelement des MOS-Typs nach Anspruch 1, bei dem in den Ecken des Halbleiterchips Eckzellen (20) ausgebildet sind, bei denen die äußerste Seite ihrer Kanalzone des zweiten Leitungstyps als eine polygonale Linie ausgebildetist, die einen zur Ecke des Halbleiterchips konvexen Bogen annähert, wobei die Fläche einer Eckzelle (20) größer ist als die Fläche einer äußeren Zelle

4. Halbleiterbauelement des MOS-Typs nach Anspruch 1, 2 oder 3, das ferner eine Halbleiterzone (101) eines ersten Leitungstyps In) enthält, die in der Oberfläche der Halbleiterschicht (1) zwischen den parallelen Seiten von zwei benachbarten inneren viereckigen Zellen angeordnet ist, wobei der Widerstand der Halbleiterzone (101) kleiner als der der Halbleiterschicht (1) ist.

5. Halbleiterbauelement des MOS-Typs gemäß einem der Ansprüche 1 bis 3, bei dem eine flache Basiszone (11) eines zweiten Leitungstyps (p) mit einer höheren Dotierungskonzentration als die der Kanalzone (3) und einer geringeren Diffusionstiefe als die der Kanalzone in einem Abschnitt der Oberflächenschicht der Kanalzone ausgebildet ist und die Zone des zweiten Leitungstyps (p) unter der flachen Basiszone (11) aus der Kanalzone (3) besteht.

## Revendications

1. Puce semi-conductrice, comportant un dispositif semi-conducteur de type MOS, comportant une couche (1) semi-conductrice d'un premier type de conductivité (n) et une pluralité de cellules intérieures et sensiblement quadrangulaires, chacune ayant quatre côtés principaux et comportant une région (3) de canal d'un second type de conductivité (p) formée dans une couche de surface de la couche (1) semi-conductrice, et une région (4) de source du premier type de conductivité (n) formée dans la couche de surface de la région de canal, dont les côtés sont parallèles aux côtés de la région de source, dans lequel la distance entre des coins des régions (3) de canal de deux cellules quadrangulaires intérieures voisines, les coins de celles-ci se faisant face en étant opposés l'un à l'autre, est plus courte que la distance entre des côtés des régions de canal de deux autres cellules quadrangulaires intérieures voisines, dont les côtés se font face en étant opposés l'un à l'autre,
caractérisé en ce que
des cellules (19) périphériques formées dans la couche de surface de la couche (1) semi-conductrice et qui ont au moins une partie du côté le plus à l'extérieur de leur région de canal du second type de conductivité parallèle à un côté de la puce semi-conductrice, sont formées sur la périphérie la plus à l'extérieur, à l'intérieur de laquelle sont formées les cellules intérieures quadrangulaires, de la puce semi-conductrice, et la surface d'une cellule (19) périphérique est plus grande que la surface d'une cellule quadrangulaire intérieure.

2. Dispositif semi-conducteur de type MOS suivant la revendication 1, dans lequel les cellules (20) de coins qui ont le côté le plus à l'extérieur de leur région de canal du second type de conductivité sous la forme d'un arc ayant sa convexité dirigée vers le coin de la puce semi-conductrice, sont formées dans les coins de la puce semi-conductrice, et dans lequel la surface d'une cellule (20) de coin est plus grande que la surface d'une cellule (19) périphérique.

3. Dispositif semi-conducteur de type MOS suivant la revendication 1, dans lequel les cellules (20) de coin qui ont le côté le plus à l'extérieur de leur région de canal du second type de conductivité sous la forme d'une ligne polygonale imittant un arc dont la convexité est tournée vers le coin de la puce semi-conductrice, sont formées dans les coins de la puce semi-conductrice, et la surface d'une cellule (20) de coin est plus grande que la surface d'une cellule (19) périphérique.

4. Dispositif semi-conducteur de type MOS suivant la revendication 1, 2 ou 3 comportant en outre une région (101) semi-conductrice d'un premier type de conductivité (n) disposée dans la surface de la couche (1) semi-conductrice entre les côtés parallèles de deux cellules intérieures voisines quadrangulaires, la résistivité de la région (101) semi-conductrice étant plus faible que celle de la couche (1) semi-conductrice.

5. Dispositif semi-conducteur de type MOS suivant l'une quelconque des revendications 1 à 3, dans lequel une région (11) de base mince d'un second type de conductivité (p) ayant une concentration en impuretés plus élevée que celle de la région (3) de canal et une profondeur de diffusion plus mince que celle de la région du canal, est formée dans une partie de la couche de surface de la région de canal et la région du second type de conductivité (p) sous la région (11) de base mince est constituée de la région (3) de canal.
